# EUROPEAN PATENT APPLICATION

(11) **EP 4 831 653 A1**
(43) Date of publication of application: **28.10.2026**
(21) Application number: 24919846.6
(22) Date of filing: 04.11.2024
(51) Int. Cl.: G01R 15/24

(54) **CURRENT DETERMINATION METHOD AND APPARATUS BASED ON OPTICAL CURRENT TRANSFORMER**

(30) Priority: 22.01.2024 CN 202410088925
(71) Applicant: Siemens Aktiengesellschaft, 80333 München (DE)
(72) Inventor: ZHAO, Shuyao, Nanjing, Jiangsu 211100 (CN); WANG, Qian, Nanjing, Jiangsu 211100 (CN); CAO, Qi, Nanjing, Jiangsu 211100 (CN); SUN, Xuan, Nanjing, Jiangsu 211100 (CN)
(74) Representative: HKW Intellectual Property PartG mbB
(86) International application number: PCT/CN2024/129739
(87) International publication number: WO 2025/156766

(57) **Abstract**

The present invention provides a method and apparatus for determining current based on an optical current transformer. The optical current transformer is used for sensing a real-time current of a target device; the real-time current is an alternating current; the optical current transformer corresponds to a light source; and the light source is used for providing incident light. The method includes: acquiring an input light intensity of the incident light; acquiring a real-time output light intensity corresponding to emergent light of the optical current transformer according to a sampling period; determining a real-time degree of a target rotation angle of the optical current transformer based on the input light intensity and the real-time output light intensity; monitoring whether the target rotation angle exceeds a monotonic interval of a sine function based on the real-time degree; determining a final rotation angle based on a monitoring result and the real-time degree of the target rotation angle; and determining the real-time current of the target device based on the final rotation angle.

## Description

### TECHNICAL FIELD

The present invention relates to the field of transformers, and in particular, to a method and apparatus for determining current based on an optical current transformer.

### BACKGROUND

For a magneto-optical Optical Current Transformer (OCT), the operating principle thereof mainly utilizes the Faraday magneto-optical effect to calculate a primary-side current. Specifically, in a magneto-optical material, an external magnetic field can cause a corresponding deflection of a linear polarization plane propagating along a magnetic field direction in the medium, and a deflection angle is a total rotation angle *α*. The angle of deflection of incident light is related to the strength of the magnetic field (the magnitude of current passing through), as well as the length over which the light interacts with the magnetic field in a transparent substance and the properties of the material. Typically, the total rotation angle *α* can be expressed as *α* = *β* · *V* · *d*, where *B* is the magnetic induction intensity and is proportional to the magnitude of the current flowing through the target device, *V* is the Verdet constant related to the material and wavelength of the optical current transformer, and *d* is the path through which a light beam passes in an optical glass ring of the optical current transformer.

Generally, the transmission axis of a polarizer is arranged to form a 45° angle with the transmission axis of an analyzer, and thus the rotation angle *α=θ+*45°, where *θ* = *β* · *V* · *d*, i.e., *θ* is the deflection angle caused by the magnetic field generated by the current of the target device. According to Malus law, a light intensity relationship between input and output is ${E}_{o} = γ ⋅ {E}_{i} ⋅ {cos}^{2} \left(B⋅V⋅d+\frac{π}{4}\right) = 0.5 ⋅ γ ⋅ {E}_{i} ⋅ \left[1-sin\left(2⋅B⋅V⋅d\right)\right]$, where *γ* is the light transmission coefficient in the optical glass used in the optical current transformer, *Eᵢ* is the input light intensity, and *Eₒ* is the output light intensity. Typically, the total rotation angle *α* ranges within [0°, 90°]. In this case, the corresponding Faraday rotation angle can be accurately calculated by measuring the input light intensity and the output light intensity, and thus the magnitude of the primary current can be restored.

Due to limitations of the optical material and the structural parameters of the transformer, when the peak current flowing through the primary-side conductor exceeds certain critical value, the range of the rotation angle *φ* = 2 · *B* · *V* · *d* for the primary-side current may exceed the monotonic interval [-90°, 90°] of the sine function. In this case, the rotation angle satisfying the relationship between the input light intensity and the output light intensity is no longer unique, causing the original calculation method to fail to correctly obtain the primary current. Therefore, the measurement current range of optical current transformers is generally small.

### SUMMARY

In view of this, the present invention provides a method for determining current based on an optical current transformer. The optical current transformer is used for sensing a real-time current of a target device, and the real-time current is an alternating current. The optical current transformer corresponds to a light source, and the light source is used for providing incident light. The method includes:
acquiring an input light intensity of the incident light;
acquiring a real-time output light intensity corresponding to emergent light of the optical current transformer according to a sampling period;
determining a real-time degree of a target rotation angle of the optical current transformer based on the input light intensity and the real-time output light intensity;
monitoring whether the target rotation angle exceeds a monotonic interval of a sine function based on the real-time degree;
determining a final rotation angle based on a monitoring result and the real-time degree of the target rotation angle; and
determining the real-time current of the target device based on the final rotation angle.

According to the method described above, optionally, the determining a final rotation angle based on a monitoring result and the real-time degree of the target rotation angle includes:
if the monitoring result indicates that the target rotation angle exceeds the monotonic interval of the sine function and the target rotation angle corresponds to a positive half-cycle of a current waveform, using a real-time degree of a complementary angle of the target rotation angle as the final rotation angle; and/or
if the monitoring result indicates that the target rotation angle exceeds the monotonic interval of the sine function and the target rotation angle corresponds to a negative half-cycle of the current waveform, using a difference between -π and the real-time degree of the target rotation angle as the final rotation angle.

According to the method described above, optionally, before the monitoring whether the target rotation angle exceeds a monotonic interval of a sine function based on the real-time degree, the method further includes:
determining whether a product of a current real-time degree of the target rotation angle and a previous real-time degree is less than or equal to 0, and whether the previous real-time degree is less than 0; and
if both determination results are Yes, triggering an operation of monitoring whether the target rotation angle exceeds the monotonic interval of the sine function based on the real-time degree.

According to the method described above, optionally, the monitoring whether the target rotation angle exceeds a monotonic interval of a sine function based on the real-time degree includes: if it is determined that an absolute value of a difference between the real-time degree of the target rotation angle and the real-time degree of the complementary angle of the target rotation angle is in a monotonically increasing state, or is in a monotonically decreasing state after being in a monotonically increasing state, then determining that the monitoring result is Yes; and
the determining a final rotation angle based on a monitoring result and the real-time degree of the target rotation angle includes: using the real-time degree of the complementary angle of the target rotation angle as the final rotation angle.

According to the method described above, optionally, after determining that the absolute value of the difference between the real-time degree of the target rotation angle and the real-time degree of the complementary angle of the target rotation angle is in a monotonically increasing state and then in a monotonically decreasing state, the method further includes: if it is determined that the real-time degree of the target rotation angle and the real-time degree of the complementary angle of the target rotation angle are again in a monotonically increasing state, then determining that the monitoring result is No; and
the determining a final rotation angle based on a monitoring result and the real-time degree of the target rotation angle includes: using the real-time degree of the target rotation angle as the final rotation angle.

According to the method described above, optionally, after determining that the target rotation angle returns to be within the monotonic interval of the sine function, the method further includes: if it is determined that the real-time degree of the target rotation angle and the real-time degree of the complementary angle of the target rotation angle are in a monotonically decreasing state, or are in a monotonically increasing state after being in a monotonically decreasing state, then determining that the monitoring result is Yes; and
the determining a final rotation angle based on a monitoring result and the real-time degree of the target rotation angle includes: using the difference between -π and the real-time degree of the target rotation angle as the final rotation angle.

According to the method described above, optionally, after the monitoring result changes from No to Yes, and before the determining a final rotation angle based on a monitoring result and the real-time degree of the target rotation angle, the method further includes determining at least one of the following conditions:
Condition 1: determining whether an absolute value of a difference between the real-time degree of the target rotation angle and a maximum rotation angle in the same direction is less than or equal to a preset threshold, where the maximum rotation angle is $\frac{π}{2}$ or $- \frac{π}{2}$; and
Condition 2: determining whether a time difference between a moment when a variation trend of the absolute value of the difference between the real-time degree of the target rotation angle and the real-time degree of the corresponding complementary angle reverses and a moment of a peak in the same direction of a sine wave of the real-time current exceeds a preset time threshold; and
if a determination result is Yes, determining that the monitoring result is correct.

According to the method described above, optionally, the determining a real-time degree of a target rotation angle of the optical current transformer based on the input light intensity and the real-time output light intensity includes: $φ = arc sin \left(1-\frac{{E}_{o}}{0.5 ⋅ {E}_{i}}\right)$, where *Eₒ* is the real-time output light intensity corresponding to the emergent light, *Eᵢ* is the input light intensity corresponding to the incident light, and *φ* is the target rotation angle; or
determining the real-time current of the target device according to the following formula: $i \left(t\right) = \frac{π ⋅ R ⋅ {φ}_{final}}{μ ⋅ V ⋅ d}$
where *i*(*t*) represents the real-time current at time t, *R* represents a distance between a conductor of the target device and optical glass, *φ_{final}* represents the final rotation angle, *µ* represents magnetic permeability, *V* represents the Verdet constant, and *d* represents a path through which a light beam passes in an optical glass ring.

The present invention further provides an apparatus for determining current based on an optical current transformer. The optical current transformer is used for sensing a real-time current of a target device, and the real-time current is an alternating current. The optical current transformer corresponds to a light source, and the light source is used for providing incident light. The apparatus includes:
a first acquisition unit, configured to acquire an input light intensity of the incident light;
a second acquisition unit, configured to acquire a real-time output light intensity corresponding to emergent light of the optical current transformer according to a sampling period;
a first determination unit, configured to determine a real-time degree of a target rotation angle of the optical current transformer based on the input light intensity and the real-time output light intensity;
a monitoring unit, configured to monitor whether the target rotation angle exceeds a monotonic interval of a sine function based on the real-time degree;
a second determination unit, configured to determine a final rotation angle based on a monitoring result and the real-time degree of the target rotation angle; and
a third determination unit, configured to determine the real-time current of the target device based on the final rotation angle.

According to the apparatus described above, optionally, the apparatus further includes:
a first determining unit, configured to determine whether a product of a current real-time degree of the target rotation angle and a previous real-time degree is less than or equal to 0, and whether the previous real-time degree is less than 0, and if both determination results are Yes, trigger the monitoring unit.

According to the apparatus described above, optionally, the monitoring unit is specifically configured to: if it is determined that an absolute value of a difference between the real-time degree of the target rotation angle and a real-time degree of a complementary angle of the target rotation angle is in a monotonically increasing state, or is in a monotonically decreasing state after being in a monotonically increasing state, then determine that the monitoring result is Yes; and
the second determination unit is specifically configured to: use the real-time degree of the complementary angle of the target rotation angle as the final rotation angle.

According to the apparatus described above, optionally, the monitoring unit is further specifically configured to: after determining that the absolute value of the difference between the real-time degree of the target rotation angle and the real-time degree of the complementary angle of the target rotation angle is in a monotonically increasing state and then in a monotonically decreasing state, if it is determined that the real-time degree of the target rotation angle and the real-time degree of the complementary angle of the target rotation angle are again in a monotonically increasing state, then determine that the monitoring result is No; and
the second determination unit is further specifically configured to: use the real-time degree of the target rotation angle as the final rotation angle.

According to the optical current transformer described above, optionally, the monitoring unit is further specifically configured to: after determining that the target rotation angle returns to be within the monotonic interval of the sine function, if it is determined that the real-time degree of the target rotation angle and the real-time degree of the complementary angle of the target rotation angle are in a monotonically decreasing state, or are in a monotonically increasing state after being in a monotonically decreasing state, then determine that the monitoring result is Yes; and
the second determination unit is further specifically configured to: use a difference between - π and the real-time degree of the target rotation angle as the final rotation angle.

According to the apparatus described above, optionally, the apparatus further includes a second determining unit, which is configured to, after the monitoring result changes from No to Yes, and before determining the final rotation angle based on the monitoring result and the real-time degree of the target rotation angle, determine at least one of the following conditions:
Condition 1: determine whether an absolute value of a difference between the real-time degree of the target rotation angle and a maximum rotation angle in the same direction is less than or equal to a preset threshold, where the maximum rotation angle is $\frac{π}{2}$ or $- \frac{π}{2}$; and
Condition 2: determine whether a time difference between a moment when a variation trend of the absolute value of the difference between the real-time degree of the target rotation angle and the real-time degree of the corresponding complementary angle reverses and a moment of a peak in the same direction of a sine wave of the real-time current exceeds a preset time threshold; and if a determination result is Yes, determine that the monitoring result is correct.

The present invention further provides an apparatus for determining current based on an optical current transformer, which includes:
at least one memory, configured to store instructions; and
at least one processor, configured to perform any one of the methods for determining current based on an optical current transformer according to the instructions stored in the memory.

The present invention still further provides a readable storage medium. The readable storage medium has machine-readable instructions stored therein, and the machine-readable instructions, when executed by a machine, causes the machine to perform any one of the methods for determining current based on an optical current transformer.

It can be seen from the above solutions that the present invention first monitors whether the target rotation angle exceeds the monotonic interval of the sine function, then determines the final rotation angle based on the monitoring result and the real-time degree of the target rotation angle, and finally obtains a relatively accurate current of the target device based on the final rotation angle. The method can avoid improvements to hardware of the optical current transformer, reduce manufacturing difficulty and production costs, and effectively expand a current measurement range of the optical current transformer.

### BRIEF DESCRIPTION OF THE DRAWINGS

Preferred embodiments of the present invention will be described in detail below with reference to the accompanying drawings, so that those of ordinary skill in the art will have a clearer understanding of the above and other features and advantages of the present invention. In the figures:
FIG. 1A is a schematic flowchart of a method for determining current based on an optical current transformer according to an embodiment of the present invention.
FIG. 1B is an exemplary diagram of an optical current transformer.
FIG. 2 is a schematic flowchart of a method for determining current based on an optical current transformer according to another embodiment of the present invention.
FIG. 3 is a schematic structural diagram of an apparatus for determining current based on an optical current transformer according to an embodiment of the present invention.
FIG. 4 is a schematic structural diagram of an apparatus for determining current based on an optical current transformer according to another embodiment of the present invention.

### DETAILED DESCRIPTION

To make the objectives, technical solutions, and advantages of the present invention clearer, the following embodiments are provided to further describe the present invention in detail. The nouns and pronouns about people used herein are not limited to specific genders.

To expand a current measurement range of an optical current transformer, the present invention adopts the following manner to determine how to correctly restore a primary-side current when a rotation angle exceeds a monotonic interval of a sine function. The primary-side current can be understood as the current of a target device, and the target device is a primary-side device.

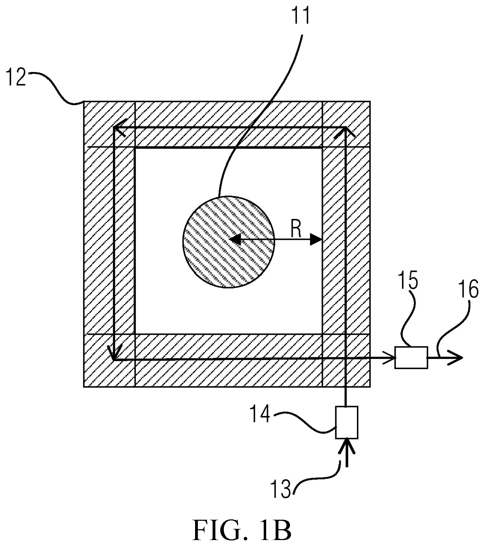

As shown in FIG. 1B, for a magneto-optical glass type optical current transformer, incident light 13 emitted by an LED passes through a polarizer 14 and becomes linearly polarized light. After the light beam travels around a primary conductor 11 in an optical glass 12 for one circle, based on the Faraday magneto-optical effect, a polarization plane thereof rotates, and the rotation angle is proportional to a line integral of a magnetic field intensity along a path of the polarized light passing through the optical glass.

Based on this, the inventors conceived of determining a real-time current value of a device based on the rotation angle of the polarization plane.

### Embodiment 1

This embodiment provides a method for determining current based on an optical current transformer. The optical current transformer is specifically a magneto-optical optical current transformer and is used for sensing a real-time current of a target device. The real-time current is an alternating current, and a current waveform thereof is a sine wave. An executive body of the method is an apparatus for determining current based on an optical current transformer. The apparatus may be integrated into a relay protection device. The relay protection device can determine the current based on the optical current transformer and perform corresponding relay protection operations. The optical current transformer corresponds to a light source, and the light source can provide incident light.

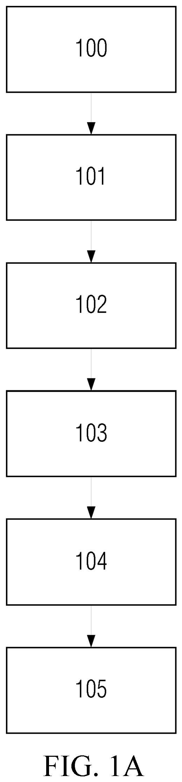

FIG. 1 shows the method for determining current based on an optical current transformer according to this embodiment. The method for determining current based on an optical current transformer includes:
Step 100: Acquire an input light intensity of the incident light.

A light source can emit light. Light that enters the optical current transformer is incident light, and light emitted from the optical current transformer is emergent light. After the incident light enters the current transformer, due to the action of a magnetic field generated by the current, for example, a magnetic field generated by a primary-side current, a polarization plane is deflected, that is, the incident light becomes emergent light after being deflected by certain angle.

For the incident light, the input light intensity thereof is constant, and thus it needs to be acquired only once. The acquisition method may be pre-notified by the manufacturer, or may be obtained indirectly through sampling values of the emergent light and approximated by software filtering, which will not be described in detail herein.

Step 101: Acquire a real-time output light intensity corresponding to emergent light of the optical current transformer according to a sampling period.

The sampling period here may be set according to actual needs, for example, sampling once every 1 microsecond.

The real-time output light intensity corresponding to the emergent light may be measured by existing technologies, such as the photoelectric effect method, interferometry, and scattering method. The light intensity may be directly acquired by the apparatus for determining current based on an optical current transformer, or may be indirectly acquired, which is not specifically limited.

It should be noted that step 101 and step 100 are not in a particular order; they may be performed sequentially or simultaneously. In this embodiment, step 100 and step 101 are taken as an example for convenience of description.

Step 102: Determine a real-time degree of a target rotation angle of the optical current transformer based on the input light intensity and the real-time output light intensity.

According to the real-time output light intensity corresponding to the emergent light and the input light intensity corresponding to the incident light, a trigonometric function value, for example, a sine trigonometric function value, can be obtained. As an exemplary description, $sinφ = 1 - \frac{{E}_{o}}{0.5 ⋅ {E}_{i}}$, where *Eₒ* is the real-time output light intensity corresponding to the emergent light, *Eᵢ* is the input light intensity corresponding to the incident light, and *φ* is the target rotation angle. In this way, $φ = arcsin \left(1-\frac{{E}_{o}}{0.5 ⋅ {E}_{i}}\right)$.

Step 103: Monitor whether the target rotation angle exceeds a monotonic interval of a sine function based on the real-time degree.

Since the output light intensity is continuously sampled, the real-time degree of the target rotation angle can be continuously obtained.

For each real-time degree of the target rotation angle, there is a corresponding real-time degree of a complementary angle. As an exemplary description, whether the target rotation angle exceeds the monotonic interval of the sine function, i.e., [-π/2, π/2], may be monitored by monitoring an absolute value of a difference between the real-time degree of the target rotation angle and the real-time degree of the corresponding complementary angle. For example, the change of the absolute value of the difference between the real-time degree of the target rotation angle and the real-time degree of the corresponding complementary angle is monitored from a zero-crossing point. For example, in a case that a current waveform after the zero-crossing point is a sine waveform, whether the absolute value of the difference between the real-time degree of the target rotation angle and the real-time degree of the complementary angle of the target rotation angle begins to be in a monotonically increasing state of the sine function is determined. If a determination result is Yes, a monitoring result is that the target rotation angle exceeds the monotonic interval of the sine function.

Specifically, other manners may also be adopted to determine whether the target rotation angle exceeds the monotonic interval of the sine function, which will not be described in detail herein.

Step 104: Determine a final rotation angle based on a monitoring result and the real-time degree of the target rotation angle.

The monitoring result here is the monitoring result generated in step 103, and different monitoring results may correspond to different final rotation angles.

As an exemplary description, the final rotation angle may be determined according to whether the real-time current corresponding to the target rotation angle is in a positive half-cycle or a negative half-cycle of the current waveform. For example, if the monitoring result is that the target rotation angle exceeds the monotonic interval of the sine function and the real-time current corresponding to the target rotation angle is in the positive half-cycle of the current waveform, the real-time degree of the complementary angle of the target rotation angle is used as the final rotation angle; and/or if the monitoring result is that the target rotation angle exceeds the monotonic interval of the sine function and the real-time current corresponding to the target rotation angle is in the negative half-cycle of the current waveform, a difference between -π and the real-time degree of the target rotation angle is used as the final rotation angle.

Here, π is 180 degrees.

The final rotation angle in this step is a true angle that can reflect the rotation angle.

Step 105: Determine the real-time current of the target device based on the final rotation angle.

As an exemplary description, the real-time current of the target device may be determined according to the following formula: $i \left(t\right) = \frac{π ⋅ R ⋅ {φ}_{final}}{μ ⋅ V ⋅ d}$ where *i*(*t*) represents the real-time current at time t, *R* represents a distance between a conductor of the target device and optical glass, *φ_{final}* represents the final rotation angle, *µ* represents magnetic permeability, *V* represents the Verdet constant, and *d* represents a path through which a light beam passes in an optical glass ring. Here, the conductor of the target device is a current carrier, for example, a wire, through which a primary-side current flows. As shown in FIG. 1B, a cross section of a conductor 11 of the target device is circular, and R is the distance between the center of the conductor 11 and optical glass 12, and the optical glass 12 is annular. Incident light 13 enters the optical glass 12 through a polarizer 14, passes through an annular path in the optical glass 12, and then passes through an analyzer 15 to form emergent light 16.

In this way, a true real-time current can be obtained according to the final rotation angle.

According to this embodiment, it is first monitored whether the target rotation angle exceeds the monotonic interval of the sine function, then the final rotation angle is determined according to the monitoring result and the real-time degree of the target rotation angle, and finally the relatively accurate current of the target device can be obtained according to the final rotation angle. The method can avoid improvements to hardware of the optical current transformer, reduce manufacturing difficulty and production costs, and effectively expand a current measurement range of the optical current transformer.

### Embodiment 2

This embodiment provides further supplementary description for the method for determining current based on an optical current transformer according to Embodiment 1.

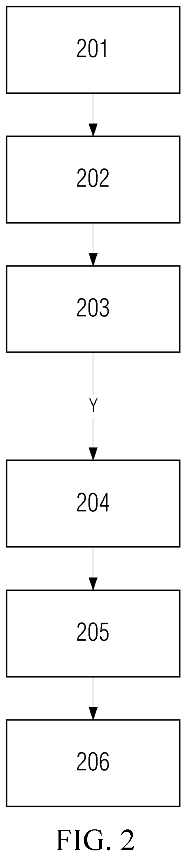

FIG. 2 is a schematic flowchart of a method for determining current based on an optical current transformer according to this embodiment. The method for determining current based on an optical current transformer includes:
Step 201: Acquire an input light intensity of the incident light.

A light source can emit light. Light that enters the optical current transformer is incident light, and light emitted from the optical current transformer is emergent light. After the incident light enters the current transformer, due to the action of a magnetic field generated by the current, for example, a magnetic field generated by a primary-side current, a polarization plane is deflected, that is, the incident light becomes emergent light after being deflected by certain angle.

For the incident light, the input light intensity thereof is constant, and thus it needs to be acquired only once. The acquisition method may be pre-notified by the manufacturer, or may be obtained indirectly through sampling values of the emergent light and approximated by software filtering, which will not be described in detail herein.

Step 202: Acquire a real-time output light intensity corresponding to emergent light of the optical current transformer according to a sampling period.

According to the real-time output light intensity corresponding to the emergent light and the input light intensity corresponding to the incident light, a trigonometric function value, for example, a sine trigonometric function value, can be obtained. As an exemplary description, $sinφ = 1 - \frac{{E}_{o}}{0.5 ⋅ {E}_{i}}$, where *Eₒ* is the real-time output light intensity corresponding to the emergent light, *Eᵢ* is the input light intensity corresponding to the incident light, and *φ* is the target rotation angle. In this way, $φ = arc sin \left(1-\frac{{E}_{o}}{0.5 ⋅ {E}_{i}}\right)$.

One real-time output light intensity corresponding to the emergent light is acquired in each sampling period.

Step 202 and step 201 are not in a particular order; they may be performed sequentially or simultaneously. In this embodiment, step 202 and step 201 are taken as an example for convenience of description.

Step 203: Determine whether a product of a current real-time degree of the target rotation angle and a previous real-time degree is less than or equal to 0, and whether the previous real-time degree is less than 0, if both determination results are Yes, perform step 204.

Step 203 is used for triggering a subsequent operation. If the previous real-time degree is less than 0, and the product of the current real-time degree and the previous real-time degree is less than or equal to 0, it indicates that the real-time degree of the target rotation angle has changed from a negative value to 0 or a positive value for the first time, which means that the current waveform of the corresponding current has just passed the zero-crossing point. Therefore, step 203 is equivalent to a trigger condition.

Step 204: Monitor whether the target rotation angle exceeds a monotonic interval of a sine function based on the real-time degree, and perform step 205.

This step specifically includes the following states:
State 0: an absolute value of a difference between the real-time degree of the target rotation angle and a real-time degree of a complementary angle of the target rotation angle is in a monotonically decreasing state, and the target rotation angle is within the monotonic interval of the sine function;
State 1: the absolute value of the difference between the real-time degree of the target rotation angle and the real-time degree of the complementary angle of the target rotation angle begins to be in a monotonically increasing state, and the target rotation angle exceeds the monotonic interval of the sine function;
State 2: the absolute value of the difference between the real-time degree of the target rotation angle and the real-time degree of the complementary angle of the target rotation angle is in a monotonically decreasing state, and the target rotation angle still exceeds the monotonic interval of the sine function;
State 3: the absolute value of the difference between the real-time degree of the target rotation angle and the real-time degree of the complementary angle of the target rotation angle is again in a monotonically increasing state, and the target rotation angle returns to be within the monotonic interval of the sine function;
State 4: the absolute value of the difference between the real-time degree of the target rotation angle and the real-time degree of the complementary angle of the target rotation angle is in a monotonically decreasing state, and the target rotation angle again exceeds the monotonic interval of the sine function; and
State 5: the absolute value of the difference between the real-time degree of the target rotation angle and the real-time degree of the complementary angle of the target rotation angle is in a monotonically increasing state, and the target rotation angle still exceeds the monotonic interval of the sine function; and
then, if it is determined that the absolute value of the difference between the real-time degree of the target rotation angle and the real-time degree of the complementary angle of the target rotation angle is again in a monotonically decreasing state, it returns to State 0.

The above states are arranged in sequence, from State 0 to State 5 and then back to State 0.

When the target rotation angle is within the monotonic interval of the sine function, the monitoring result is No; when the target rotation angle exceeds the monotonic interval of the sine function, the monitoring result is Yes.

Step 205: Determine a final rotation angle based on a monitoring result and the real-time degree of the target rotation angle.

As an exemplary description, details are as follows:
State 0: the final rotation angle is the real-time degree of the target rotation angle.

State 1: the final rotation angle is the real-time degree of the complementary angle of the target rotation angle.

State 2: the final rotation angle is the real-time degree of the complementary angle of the target rotation angle.

State 3: the final rotation angle is the real-time degree of the target rotation angle.

State 4: the final rotation angle is -π minus the real-time degree of the target rotation angle.

State 5: the final rotation angle is -π minus the real-time degree of the target rotation angle.

Accordingly, different states correspond to different monitoring results, and different monitoring results correspond to different real-time degrees.

Step 206: Determine the real-time current of the target device based on the final rotation angle.

Specifically, the real-time current of the target device may be determined according to the following formula: $i \left(t\right) = \frac{π ⋅ R ⋅ {φ}_{final}}{μ ⋅ V ⋅ d}$ where *i*(*t*) represents the real-time current at time t, *R* represents a distance between a primary conductor and optical glass, *φ_{final}* represents the final rotation angle, *µ* represents magnetic permeability, *V* represents the Verdet constant, and *d* represents a path through which a light beam passes in an optical glass ring.

Optionally, after the monitoring result in step 204 changes from No to Yes, and before step 205, the method further includes determine at least one of the following conditions:
Condition 1: determine whether an absolute value of a difference between the target rotation angle and a maximum rotation angle in the same direction is less than or equal to a preset threshold, where the maximum rotation angle is $\frac{π}{2}$ or $- \frac{π}{2}$; and
Condition 2: determine whether a deviation time difference between a moment when a variation trend of the absolute value of the difference between the target rotation angle and the corresponding complementary angle reverses and a moment of a peak in the same direction of the sine wave of the real-time current exceeds a preset time threshold.

If the determining result is Yes, perform step 205. The "same direction" here means being both in the positive half-cycle or both in the negative half-cycle.

Both Condition 1 and Condition 2 here are for further verification of the monitoring result being Yes, that is, for further verifying whether it has truly exceeded the monotonic interval of the sine function.

For Condition 1, it is used for determining a range of the absolute value of the difference between the real-time degree of the target rotation angle and the adjacent maximum rotation angle. If the real-time degree of the target rotation angle corresponds to the positive half-cycle of the sine waveform of the real-time current, whether an absolute value of a difference between the target rotation angle and $\frac{π}{2}$ is less than or equal to a preset threshold is determined. If the real-time degree of the target rotation angle corresponds to the negative half-cycle of the sine waveform of the real-time current, whether an absolute value of a difference between the real-time degree of the target rotation angle and $- \frac{π}{2}$ is less than or equal to a preset threshold is determined. If the absolute value of the difference differs too much from the preset threshold, it indicates that the current real-time degree of the target rotation angle is still some time away from the maximum rotation angle, and at this time it is impossible to exceed the monotonic interval of the sine function. Therefore, it can be determined that the previous monitoring result is incorrect.

For Condition 2, it is used for determining whether a position where a turning point occurs in the variation trend of the absolute value of the difference between the real-time degree of the target rotation angle *φ* and the real-time degree of the complementary angle is at a midpoint position of the positive half-cycle or the negative half-cycle, so as to distinguish from the case where the rotation angle is at a critical value of the monotonic interval. If the determining result is Yes, it can further indicate that the previous monitoring result is correct; otherwise, it indicates that the monitoring result is incorrect, and it does not exceed the monotonic interval of the sine function at this time.

Therefore, in this embodiment, after the monitoring result of step 204 changes from No to Yes, Condition 1 may be combined, or Condition 2 may be combined, or both Condition 1 and Condition 2 may be combined. Specifically, the selection may be made according to actual needs, so as to further confirm whether it has truly exceeded the monotonic interval of the sine function.

According to the method for determining current based on an optical current transformer of this embodiment, whether it has exceeded the monotonic interval of the sine function can be determined by the absolute value of the difference between the real-time degree of the target rotation angle and the real-time degree of the complementary angle thereof. The method is simple and convenient, and requires a relatively small amount of computation.

### Embodiment 3

This embodiment provides a specific example for describing the method for determining current based on an optical current transformer of the foregoing embodiments.

In this embodiment, sampling is performed according to a preset period on the real-time output light intensity of the emergent light of the optical current transformer corresponding to the target device.

For each sampled value, the real-time degree of the corresponding target rotation angle *φ* is acquired according to the following formula: $φ = arc sin \left(1-\frac{{E}_{o}}{0.5 ⋅ {E}_{i}}\right)$, where *Eₒ* is the real-time output light intensity corresponding to the emergent light, and *Eᵢ* is the input light intensity corresponding to the incident light.

Based on the real-time degree of the target rotation angle *φ* acquired from the sampled value of the current real-time output light intensity, whether a product thereof with a previous real-time degree is less than or equal to 0, and whether the previous real-time degree is less than 0 are determined. If both determination results are Yes, the process proceeds to State 0, the current sampled value is recorded as a first sampled value, the current real-time degree of the target rotation angle is a first real-time degree, and an absolute value of a first difference between the first real-time degree and a complementary angle thereof is acquired. A current first final rotation angle is the first real-time degree. In this case, the real-time current of the target device determined based on the first final rotation angle is $i \left(t\right) = \frac{π ⋅ R ⋅ {φ}_{final}}{μ ⋅ V ⋅ d}$, where t in the formula is the sampling time corresponding to the first sampled value, and the final rotation angle is the first real-time degree.

Next, a second real-time degree is acquired, and an absolute value of a second difference between the second real-time degree and a complementary angle thereof is acquired. It is identified that the absolute value of the second difference is less than the absolute value of the first difference. In this case, a second final rotation angle is the second real-time degree. The real-time current of the target device determined based on the second final rotation angle is $i \left(t\right) = \frac{π ⋅ R ⋅ {φ}_{final}}{μ ⋅ V ⋅ d}$, where t in the formula is the sampling time corresponding to the second sampled value, and the final rotation angle is the second real-time degree.

Next, a third real-time degree is acquired, and an absolute value of a third difference between the third real-time degree and a complementary angle thereof is acquired. It is identified that the absolute value of the third difference is less than the absolute value of the second difference. In this case, a third final rotation angle is the third real-time degree. The real-time current of the target device determined based on the third final rotation angle is $i \left(t\right) = \frac{π ⋅ R ⋅ {φ}_{final}}{μ ⋅ V ⋅ d}$, where t in the formula is the sampling time corresponding to the third sampled value, and the final rotation angle is the third real-time degree.

By analogy, until it is identified that an absolute value of a p-th difference is greater than an absolute value of a (p-1)-th difference, an absolute value of a difference between a p-th real-time degree and a positive maximum rotation angle $\frac{π}{2}$ is less than a preset threshold, and a time difference between a sampling moment of the p-th difference and a sampling moment of a peak of the positive half-cycle of the sine wave of the real-time current exceeds a preset time threshold, the process proceeds to State 1. At this time, it is monitored that the target rotation angle exceeds the monotonic interval of the sine function. Of course, in actual practice, it is also possible to monitor that the absolute values of 3, 4 or more differences are all greater than the absolute value of the previous difference, and then determine that the monitoring result is that the target rotation angle is in a monotonically increasing state, which may be specifically selected according to actual needs. In this case, a p-th final rotation angle is (180° - the p-th real-time degree). The real-time current of the target device determined based on the p-th final rotation angle is $i \left(t\right) = \frac{π ⋅ R ⋅ {φ}_{final}}{μ ⋅ V ⋅ d}$, where t in the formula is the sampling time corresponding to a p-th sampled value, and the final rotation angle is (180° - the p-th real-time degree).

Next, a (p+1)-th real-time degree is acquired, and an absolute value of a (p+1)-th difference between the (p+1)-th real-time degree and a complementary angle thereof is acquired. It is identified that the absolute value of the (p+1)-th difference is greater than the absolute value of the p-th difference. In this case, a (p+1)-th final rotation angle is the complementary angle of the (p+1)-th real-time degree. The real-time current of the target device determined based on the (p+1)-th final rotation angle is $i \left(t\right) = \frac{π ⋅ R ⋅ {φ}_{final}}{μ ⋅ V ⋅ d}$, where t in the formula is the sampling time corresponding to a (p+1)-th sampled value, and the final rotation angle is (180° - the (p+1)-th real-time degree).

Next, a (p+2)-th real-time degree is acquired, and an absolute value of a (p+2)-th difference between the (p+2)-th real-time degree and a complementary angle thereof is acquired. It is identified that the absolute value of the (p+2)-th difference is greater than the absolute value of the (p+1)-th difference. The real-time current of the target device determined based on a (p+2)-th final rotation angle is $i \left(t\right) = \frac{π ⋅ R ⋅ {φ}_{final}}{μ ⋅ V ⋅ d}$, where t in the formula is the sampling time corresponding to a (p+2)-th sampled value, and the final rotation angle is (180° - the (p+2)-th real-time degree).

By analogy, until it is identified that an absolute value of a j-th difference is less than an absolute value of a (j-1)-th difference, the process proceeds to State 2.

At this time, it is monitored that the target rotation angle exceeds the monotonic interval of the sine function. Of course, in actual practice, it is also possible to monitor that the absolute values of 3, 4 or more differences are all less than the absolute value of the previous difference, and then determine that the monitoring result is that the target rotation angle is in a monotonically decreasing state, which may be specifically selected according to actual needs. The real-time current of the target device determined based on a j-th final rotation angle is $i \left(t\right) = \frac{π ⋅ R ⋅ {φ}_{final}}{μ ⋅ V ⋅ d}$ where t in the formula is the sampling time corresponding to a j-th sampled value, and the final rotation angle is (180° - a j-th real-time degree).

Next, a (j+1)-th real-time degree is acquired, and an absolute value of a (j+1)-th difference between the (j+1)-th real-time degree and a complementary angle thereof is acquired. It is identified that the absolute value of the (j+1)-th difference is less than the absolute value of the j-th difference. In this case, a (j+1)-th final rotation angle is the complementary angle of the (j+1)-th real-time degree. The real-time current of the target device determined based on the j-th final rotation angle is $i \left(t\right) = \frac{π ⋅ R ⋅ {φ}_{final}}{μ ⋅ V ⋅ d}$, where t in the formula is the sampling time corresponding to a (j+1)-th sampled value, and the final rotation angle is (180° - the (j+1)-th real-time degree).

By analogy, until it is identified that an absolute value of an m-th difference is greater than an absolute value of an (m-1)-th difference, the process proceeds to State 3, where the monitoring result is that the target rotation angle returns to be within the monotonic interval of the sine function. In this case, an m-th final rotation angle is an m-th real-time degree. The real-time current of the target device determined based on the m-th final rotation angle is $i \left(t\right) = \frac{π ⋅ R ⋅ {φ}_{final}}{μ ⋅ V ⋅ d}$, where t in the formula is the sampling time corresponding to the m-th sampled value, and the final rotation angle is the m-th real-time degree.

Next, continue monitoring the real-time degree of the target rotation angle until it is identified that an absolute value of an n-th difference is less than an absolute value of an (n-1)-th difference, but an absolute value of a difference between an n-th real-time degree and a negative maximum rotation angle $- \frac{π}{2}$ is greater than a preset threshold, which indicates that it does not exceed the monotonic interval of the sine function at this time. In this case, an n-th final rotation angle is an n-th real-time degree. The real-time current of the target device determined based on the n-th final rotation angle is $i \left(t\right) = \frac{π ⋅ R ⋅ {φ}_{final}}{μ ⋅ V ⋅ d}$, where t in the formula is the sampling time corresponding to an n-th sampled value, and the final rotation angle is the n-th real-time degree.

Next, continue monitoring the real-time degree of the target rotation angle. It is identified that an absolute value of an (n+1)-th difference is less than the absolute value of the n-th difference, and an absolute value of a difference between an (n+1)-th real-time degree and the negative maximum rotation angle $- \frac{π}{2}$ is less than a preset threshold, and a time difference between a sampling moment of the (n+1)-th difference and a sampling moment of a peak of the negative half-cycle of the sine wave of the real-time current exceeds a preset time threshold, the process proceeds to State 4. In this case, the monitoring result is that the target rotation angle again exceeds the monotonic interval of the sine function. In this case, an (n+1)-th final rotation angle is (-180° - the (n+1)-th real-time degree). The real-time current of the target device determined based on the (n+1)-th final rotation angle is $i \left(t\right) = \frac{π ⋅ R ⋅ {φ}_{final}}{μ ⋅ V ⋅ d}$, where t in the formula is the sampling time corresponding to an (n+1)-th sampled value, and the final rotation angle is the (n+1)-th real-time degree.

Next, an absolute value of an (n+2)-th difference is less than the absolute value of the (n+1)-th difference. In this case, a (n+2)-th final rotation angle is (-180° - an (n+2)-th real-time degree). The real-time current of the target device determined based on the (n+2)-th final rotation angle is $i \left(t\right) = \frac{π ⋅ R ⋅ {φ}_{final}}{μ ⋅ V ⋅ d}$, where t in the formula is the sampling time corresponding to an (n+2)-th sampled value, and the final rotation angle is (-180° - the (n+2)-th real-time degree).

By analogy, until it is monitored that an absolute value of a q-th difference is greater than an absolute value of a (q-1)-th difference, the process proceeds to State 5. In this case, a q-th final rotation angle is (-180° - a q-th real-time degree). The real-time current of the target device determined based on the q-th final rotation angle is $i \left(t\right) = \frac{π ⋅ R ⋅ {φ}_{final}}{μ ⋅ V ⋅ d}$, where t in the formula is the sampling time corresponding to a q-th sampled value, and the final rotation angle is (-180° - the q-th real-time degree).

Next, a (q+1)-th difference is greater than the q-th difference. In this case, a (q+1)-th final rotation angle is (-180° - a (q+1)-th real-time degree). The real-time current of the target device determined based on the (q+1)-th final rotation angle is $i \left(t\right) = \frac{π ⋅ R ⋅ {φ}_{final}}{μ ⋅ V ⋅ d}$, where t in the formula is the sampling time corresponding to a (q+1)-th sampled value, and the final rotation angle is (-180° - the (q+1)-th real-time degree).

By analogy, until it is monitored again that the difference between the real-time degree of the target rotation angle and the real-time degree of the complementary angle of the target rotation angle is in a monotonically decreasing state, the process returns to State 0.

### Embodiment 4

This embodiment provides an apparatus for determining current based on an optical current transformer, which is configured to perform the method for determining current based on an optical current transformer of Embodiment 1. The apparatus may be integrated into a relay protection device, or the apparatus may be regarded as the relay protection device itself. The optical current transformer is used for sensing a real-time current of a target device. The target device may be a primary-side device. The real-time current is an alternating current. The optical current transformer corresponds to a light source, and the light source is used for providing incident light.

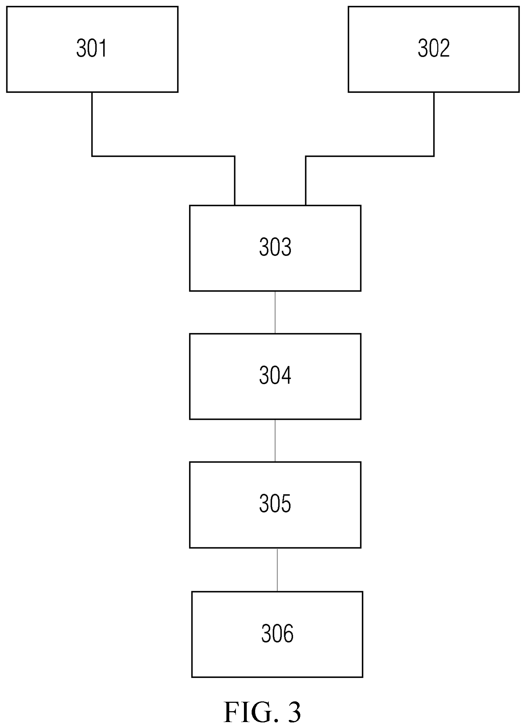

FIG. 3 is a schematic structural diagram of an apparatus for determining current based on an optical current transformer according to this embodiment. The apparatus for determining current based on an optical current transformer includes a first acquisition unit 301, a second acquisition unit 302, a first determination unit 303, a monitoring unit 304, a second determination unit 305, and a third determination unit 306.

The first acquisition unit 301 is configured to acquire an input light intensity of the incident light. The second acquisition unit 302 is configured to acquire a real-time output light intensity corresponding to emergent light of the optical current transformer according to a sampling period. The first determination unit 303 is configured to determine a real-time degree of a target rotation angle of the optical current transformer based on the input light intensity and the real-time output light intensity. The monitoring unit 304 is configured to monitor whether the target rotation angle exceeds a monotonic interval of a sine function based on the real-time degree. The second determination unit 305 is configured to determine a final rotation angle based on a monitoring result and the real-time degree of the target rotation angle. The third determination unit 306 is configured to determine the real-time current of the target device based on the final rotation angle.

Optionally, the second determination unit 305 is specifically configured to:
if the monitoring result indicates that the target rotation angle exceeds the monotonic interval of the sine function and the target rotation angle corresponds to a positive half-cycle of a current waveform, use a real-time degree of a complementary angle of the target rotation angle as the final rotation angle; and/or
if the monitoring result indicates that the target rotation angle exceeds the monotonic interval of the sine function and the target rotation angle corresponds to a negative half-cycle of the current waveform, use a difference between -π and the real-time degree of the target rotation angle as the final rotation angle.

Optionally, the first determination unit 303 is specifically configured to determine the real-time degree of the target rotation angle according to the following formula: $φ = arc sin \left(1-\frac{{E}_{o}}{0.5 ⋅ {E}_{i}}\right) ,$ where *Eₒ* is the real-time output light intensity corresponding to the emergent light, *Eᵢ* is the input light intensity corresponding to the incident light, and *φ* is the target rotation angle.

Optionally, the third determination unit 306 is specifically configured to:
determine the real-time current of the target device according to the following formula: $i \left(t\right) = \frac{π ⋅ R ⋅ {φ}_{final}}{μ ⋅ V ⋅ d}$
where *i*(*t*) represents the real-time current at time t, *R* represents a distance between a conductor of the target device and optical glass, *φ_{final}* represents the final rotation angle, *µ* represents magnetic permeability, *V* represents the Verdet constant, and *d* represents a path through which a light beam passes in an optical glass ring.

The working methods of the units in this embodiment are the same as those in the foregoing embodiments, which will not be repeated here.

According to this embodiment, it is first monitored whether the target rotation angle exceeds the monotonic interval of the sine function, then the final rotation angle is determined according to the monitoring result and the real-time degree of the target rotation angle, and finally the relatively accurate current of the target device can be obtained according to the final rotation angle. The method can avoid improvements to hardware of the optical current transformer, reduce manufacturing difficulty and production costs, and effectively expand a current measurement range of the optical current transformer.

### Embodiment 5

This embodiment provides further supplementary description for the apparatus for determining current based on an optical current transformer of Embodiment 4.

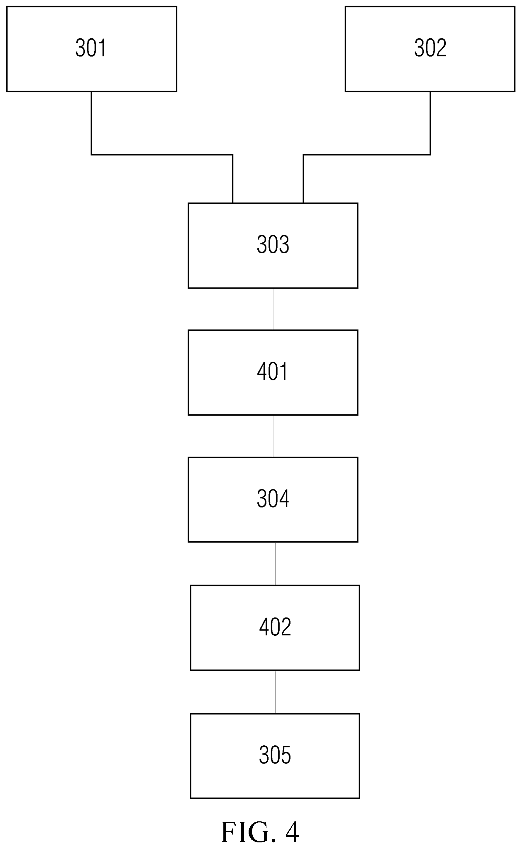

As shown in FIG. 4, the apparatus for determining current based on an optical current transformer of this embodiment, in addition to the aforementioned first acquisition unit 301, second acquisition unit 302, first determination unit 303, monitoring unit 304, second determination unit 305, and third determination unit 306, further includes a first determining unit 401 configured to determine whether a product of a current real-time degree of the target rotation angle and a previous real-time degree is less than or equal to 0, and whether the previous real-time degree is less than 0, and if both determination results are Yes, trigger the monitoring unit 304.

Optionally, the monitoring unit 304 is specifically configured to: if it is determined that an absolute value of a difference between the real-time degree of the target rotation angle and a real-time degree of a complementary angle of the target rotation angle is in a monotonically increasing state, or is in a monotonically decreasing state after being in a monotonically increasing state, then determine that the monitoring result is Yes; and correspondingly, the second determination unit 305 is specifically configured to: use the real-time degree of the complementary angle of the target rotation angle as the final rotation angle.

Optionally, the monitoring unit 304 is further specifically configured to: after determining that the absolute value of the difference between the real-time degree of the target rotation angle and the real-time degree of the complementary angle of the target rotation angle is in a monotonically increasing state and then in a monotonically decreasing state, if it is determined that the real-time degree of the target rotation angle and the real-time degree of the complementary angle of the target rotation angle are again in a monotonically increasing state, then determine that the monitoring result is No; and the second determination unit 305 is further specifically configured to: use the real-time degree of the target rotation angle as the final rotation angle.

Optionally, the monitoring unit 304 is further specifically configured to: after determining that the target rotation angle returns to be within the monotonic interval of the sine function, if it is determined that the real-time degree of the target rotation angle and the real-time degree of the complementary angle of the target rotation angle are in a monotonically decreasing state, or are in a monotonically increasing state after being in a monotonically decreasing state, then determine that the monitoring result is Yes; and the second determination unit 305 is further specifically configured to: use a difference between -π and the real-time degree of the target rotation angle as the final rotation angle.

Optionally, the apparatus for determining current based on an optical current transformer of this embodiment further includes a second determining unit 402. The second determining unit 402 is configured to, after the monitoring result of the monitoring unit 304 changes from No to Yes, and before determining the final rotation angle based on the monitoring result and the real-time degree of the target rotation angle, determine at least one of the following conditions:
Condition 1: determine whether an absolute value of a difference between the real-time degree of the target rotation angle and a maximum rotation angle in the same direction is less than or equal to a preset threshold, where the maximum rotation angle is $\frac{π}{2}$ or $- \frac{π}{2}$; and
Condition 2: determine whether a time difference between a moment when a variation trend of the absolute value of the difference between the real-time degree of the target rotation angle and the real-time degree of the corresponding complementary angle reverses and a moment of a peak in the same direction of a sine wave of the real-time current exceeds a preset time threshold; and
if a determination result is Yes, determine that the monitoring result is correct.

The working methods of the units in this embodiment are the same as those in the foregoing embodiments, which will not be repeated here.

According to the apparatus for determining current based on an optical current transformer of this embodiment, whether it has exceeded the monotonic interval can be determined by the absolute value of the difference between the real-time degree of the target rotation angle and the real-time degree of the complementary angle thereof. The method is simple and convenient, and requires a relatively small amount of computation.

The present invention also provides an apparatus for determining current based on an optical current transformer, which includes at least one memory and at least one processor. The memory is configured to store instructions. The processor is configured to perform, according to instructions stored in the memory, the method for determining current based on an optical current transformer as described in any of the foregoing embodiments. The apparatus for determining current based on an optical current transformer may be regarded as a part of a relay protection device, or may be regarded as the relay protection device itself.

Embodiments of the present invention further provide a readable storage medium. The readable storage medium has machine-readable instructions stored therein. The machine-readable instructions, when executed by a machine, cause the machine to perform the method for determining current based on an optical current transformer as described in any of the foregoing embodiments.

The readable medium has machine-readable instructions stored therein. The machine-readable instructions, when executed by a processor, cause the processor to perform any one of the foregoing methods. Specifically, a system or apparatus equipped with a readable storage medium may be provided, with software program codes for implementing the functions of any one of the above embodiments stored on the readable storage medium, and a computer or processor of the system or apparatus reads out and executes the machine-readable instructions stored in the readable storage medium.

In such a case, the program codes read from the readable storage medium can themselves implement the functions of any one of the above embodiments, and thus the machine-readable codes and the readable storage medium storing the machine-readable codes constitute a part of the present invention.

Examples of the readable storage medium include a floppy disk, a hard disk, a magneto-optical disk, an optical disk (for example, a CD-ROM, a CD-R, a CD-RW, a DVD-ROM, a DVD-RAM, a DVD-RW, or a DVD+RW), a magnetic tape, a non-volatile memory card, and an ROM. Optionally, the program codes may be downloaded from a server computer or from the cloud via a communication network.

It should be understood by those skilled in the art that various variations and modifications may be made to the above-disclosed embodiments without departing from the spirit of the present invention. Therefore, the scope of protection of the present invention should be defined by the appended claims.

It should be noted that not all steps and units in the above flowcharts and system structure diagrams are essential, and some steps or units may be omitted according to actual needs. The execution order of the steps is not fixed and may be adjusted as needed. The apparatus structures described in the above embodiments may be physical structures or logical structures, that is, some units may be implemented by the same physical entity, or some units may be implemented by multiple physical entities respectively, or may be implemented jointly by certain components in multiple independent devices.

In the above embodiments, the hardware units may be implemented mechanically or electrically. For example, a hardware unit or processor may include a permanent dedicated circuit or logic (such as a dedicated processor, FPGA or ASIC) to perform corresponding operations. A hardware unit or processor may also include programmable logic or circuits (such as a generalpurpose processor or other programmable processors), which may be temporarily configured by software to perform corresponding operations. The specific implementation manner (mechanical, or dedicated permanent circuit, or temporarily configured circuit) may be determined based on cost and time considerations.

The above descriptions are only preferred embodiments of the present invention and are not intended to limit the present invention. Any modifications, equivalent substitutions, improvements, and the like made within the spirit and principles of the present invention should be included within the scope of protection of the present invention.

## Claims

1. A method for determining current based on an optical current transformer, the optical current transformer being used for sensing a real-time current of a target device, the real-time current being an alternating current, the optical current transformer corresponding to a light source, the light source being used for providing incident light, and the method comprising:
acquiring an input light intensity of the incident light;
acquiring a real-time output light intensity corresponding to emergent light of the optical current transformer according to a sampling period;
determining a real-time degree of a target rotation angle of the optical current transformer based on the input light intensity and the real-time output light intensity;
monitoring whether the target rotation angle exceeds a monotonic interval of a sine function based on the real-time degree;
determining a final rotation angle based on a monitoring result and the real-time degree of the target rotation angle; and
determining the real-time current of the target device based on the final rotation angle.

2. The method according to claim 1, wherein the determining a final rotation angle based on a monitoring result and the real-time degree of the target rotation angle comprises:
if the monitoring result indicates that the target rotation angle exceeds the monotonic interval of the sine function and the target rotation angle corresponds to a positive half-cycle of a current waveform, using a real-time degree of a complementary angle of the target rotation angle as the final rotation angle; and/or
if the monitoring result indicates that the target rotation angle exceeds the monotonic interval of the sine function and the target rotation angle corresponds to a negative half-cycle of the current waveform, using a difference between -π and the real-time degree of the target rotation angle as the final rotation angle.

3. The method according to claim 1, wherein before the monitoring whether the target rotation angle exceeds a monotonic interval of a sine function based on the real-time degree, the method further comprises:
determining whether a product of a current real-time degree of the target rotation angle and a previous real-time degree is less than or equal to 0, and whether the previous real-time degree is less than 0; and
if both determination results are Yes, triggering an operation of monitoring whether the target rotation angle exceeds the monotonic interval of the sine function based on the real-time degree.

4. The method according to claim 3, wherein the monitoring whether the target rotation angle exceeds a monotonic interval of a sine function based on the real-time degree comprises: if it is determined that an absolute value of a difference between the real-time degree of the target rotation angle and a real-time degree of a complementary angle of the target rotation angle is in a monotonically increasing state, or is in a monotonically decreasing state after being in a monotonically increasing state, then determining that the monitoring result is Yes; and
the determining a final rotation angle based on a monitoring result and the real-time degree of the target rotation angle includes: using the real-time degree of the complementary angle of the target rotation angle as the final rotation angle.

5. The method according to claim 4, wherein after determining that the absolute value of the difference between the real-time degree of the target rotation angle and the real-time degree of the complementary angle of the target rotation angle is in a monotonically increasing state and then in a monotonically decreasing state, the method further comprises: if it is determined that the real-time degree of the target rotation angle and the real-time degree of the complementary angle of the target rotation angle are again in a monotonically increasing state, then determining that the monitoring result is No; and
the determining a final rotation angle based on a monitoring result and the real-time degree of the target rotation angle includes: using the real-time degree of the target rotation angle as the final rotation angle.

6. The method according to claim 5, wherein after determining that the target rotation angle returns to be within the monotonic interval of the sine function, the method further comprises: if it is determined that the real-time degree of the target rotation angle and the real-time degree of the complementary angle of the target rotation angle are in a monotonically decreasing state, or are in a monotonically increasing state after being in a monotonically decreasing state, then determining that the monitoring result is Yes; and
the determining a final rotation angle based on a monitoring result and the real-time degree of the target rotation angle includes: using a difference between -π and the real-time degree of the target rotation angle as the final rotation angle.

7. The method according to claim 1, wherein after the monitoring result changes from No to Yes, and before the determining a final rotation angle based on a monitoring result and the real-time degree of the target rotation angle, the method further comprises determining at least one of the following conditions:
Condition 1: determining whether an absolute value of a difference between the real-time degree of the target rotation angle and a maximum rotation angle in the same direction is less than or equal to a preset threshold, wherein the maximum rotation angle is $\frac{π}{2}$ or $- \frac{π}{2}$; and
Condition 2: determining whether a time difference between a moment when a variation trend of an absolute value of a difference between the real-time degree of the target rotation angle and a real-time degree of a corresponding complementary angle reverses and a moment of a peak in the same direction of a sine wave of the real-time current exceeds a preset time threshold; and
if a determination result is Yes, determining that the monitoring result is correct.

8. The method according to claim 1, wherein the determining a real-time degree of a target rotation angle of the optical current transformer based on the input light intensity and the real-time output light intensity comprises: $φ = arc sin \left(1-\frac{{E}_{o}}{0.5 ⋅ {E}_{i}}\right)$, wherein *Eₒ* is the real-time output light intensity corresponding to the emergent light, *Eᵢ* is the input light intensity corresponding to the incident light, and *φ* is the target rotation angle; or
determining the real-time current of the target device according to the following formula: $i \left(t\right) = \frac{π ⋅ R ⋅ {φ}_{final}}{μ ⋅ V ⋅ d}$
wherein *i*(*t*) represents the real-time current at time t, *R* represents a distance between a conductor of the target device and optical glass, *φ_{final}* represents the final rotation angle, *µ* represents magnetic permeability, *V* represents the Verdet constant, and *d* represents a path through which a light beam passes in an optical glass ring.

9. An apparatus for determining current based on an optical current transformer, the optical current transformer being used for sensing a real-time current of a target device, the real-time current being an alternating current, the optical current transformer corresponding to a light source, the light source being used for providing incident light, and the apparatus comprising:
a first acquisition unit, configured to acquire an input light intensity of the incident light;
a second acquisition unit, configured to acquire a real-time output light intensity corresponding to emergent light of the optical current transformer according to a sampling period;
a first determination unit, configured to determine a real-time degree of a target rotation angle of the optical current transformer based on the input light intensity and the real-time output light intensity;
a monitoring unit, configured to monitor whether the target rotation angle exceeds a monotonic interval of a sine function based on the real-time degree;
a second determination unit, configured to determine a final rotation angle based on a monitoring result and the real-time degree of the target rotation angle; and
a third determination unit, configured to determine the real-time current of the target device based on the final rotation angle.

10. The apparatus according to claim 9, further comprising:
a first determining unit, configured to determine whether a product of a current real-time degree of the target rotation angle and a previous real-time degree is less than or equal to 0, and whether the previous real-time degree is less than 0, and if both determination results are Yes, trigger the monitoring unit.

11. The apparatus according to claim 10, wherein the monitoring unit is specifically configured to: if it is determined that an absolute value of a difference between the real-time degree of the target rotation angle and a real-time degree of a complementary angle of the target rotation angle is in a monotonically increasing state, or is in a monotonically decreasing state after being in a monotonically increasing state, then determine that the monitoring result is Yes; and
the second determination unit is specifically configured to: use the real-time degree of the complementary angle of the target rotation angle as the final rotation angle.

12. The apparatus according to claim 11, wherein the monitoring unit is further specifically configured to: after determining that the absolute value of the difference between the real-time degree of the target rotation angle and the real-time degree of the complementary angle of the target rotation angle is in a monotonically increasing state and then in a monotonically decreasing state, if it is determined that the real-time degree of the target rotation angle and the real-time degree of the complementary angle of the target rotation angle are again in a monotonically increasing state, then determine that the monitoring result is No; and
the second determination unit is further specifically configured to: use the real-time degree of the target rotation angle as the final rotation angle.

13. The apparatus according to claim 12, wherein the monitoring unit is further specifically configured to: after determining that the target rotation angle returns to be within the monotonic interval of the sine function, if it is determined that the real-time degree of the target rotation angle and the real-time degree of the complementary angle of the target rotation angle are in a monotonically decreasing state, or are in a monotonically increasing state after being in a monotonically decreasing state, then determine that the monitoring result is Yes; and
the second determination unit is further specifically configured to: use a difference between -π and the real-time degree of the target rotation angle as the final rotation angle.

14. The apparatus according to any one of claims 9 to 13, further comprising a second determining unit, configured to, after the monitoring result changes from No to Yes, and before determining the final rotation angle based on the monitoring result and the real-time degree of the target rotation angle, determine at least one of the following conditions:
Condition 1: determine whether an absolute value of a difference between the real-time degree of the target rotation angle and a maximum rotation angle in the same direction is less than or equal to a preset threshold, wherein the maximum rotation angle is $\frac{π}{2}$ or $- \frac{π}{2}$; and
Condition 2: determine whether a time difference between a moment when a variation trend of the absolute value of the difference between the real-time degree of the target rotation angle and the real-time degree of the corresponding complementary angle reverses and a moment of a peak in the same direction of a sine wave of the real-time current exceeds a preset time threshold; and
if a determination result is Yes, determine that the monitoring result is correct.

15. An apparatus for determining current based on an optical current transformer, comprising:
at least one memory, configured to store instructions; and
at least one processor, configured to perform the method for determining current based on an optical current transformer according to any one of claims 1 to 8 according to the instructions stored in the memory.

16. A readable storage medium, having machine-readable instructions stored therein, and the machine-readable instructions, when executed by a machine, causing the machine to perform the method for determining current based on the optical current transformer according to any one of claims 1 to 8.
